# EUROPEAN PATENT SPECIFICATION

(11) **EP 2 239 769 B1**
(45) Date of publication and mention of the grant of the patent: **06.11.2019**
(21) Application number: 09704593.4
(22) Date of filing: 23.01.2009
(51) Int. Cl.: C23C 14/04, H01L 23/00

(54) **SELF-ALIGNED METAL MASK ASSEMBLY FOR SELECTIVELY DEPOSITING THIN FILMS ON MICROELECTRONIC SUBSTRATES AND DEVICES, AND METHOD OF USE**
SELBSTAUSGERICHTETE METALLMASKENANORDNUNG ZUR SELEKTIVEN ABLAGERUNG VON DÜNNSCHICHTEN AUF MIKROELEKTRONISCHEN SUBSTRATEN UND VORRICHTUNGEN SOWIE VERWENDUNGSVERFAHREN
ENSEMBLE DE MASQUES MÉTALLIQUES AUTO ALIGNÉS PERMETTANT DE DÉPOSER, DE MANIÈRE SÉLECTIVE, DES FINES COUCHES SUR DES DISPOSITIFS ET DES SUBSTRATS MICROÉLECTRONIQUES ET PROCÉDÉ D'UTILISATION

(30) Priority: 25.01.2008 ES 200800192
(43) Date of publication of application: 13.10.2010
(73) Proprietor: Consejo Superior De Investigaciones Científicas, 28006 Madrid (ES)
(72) Inventor: JORDA SANUY, Xavier, 08193 Bellaterra (Barcelona) (ES); PERPIÑA GIRIBET, Xavier, 08193 Bellaterra (Barcelona) (ES); VELLVEHI HERNANDEZ, Miquel, 08193 Bellaterra (Barcelona) (ES); SANCHEZ SANCHEZ, David, 08193 Bellaterra (Barcelona) (ES); GODIGNON, Philippe, 08193 Bellaterra (Barcelona) (ES)
(74) Representative: Pons
(86) International application number: PCT/ES2009/070005
(87) International publication number: WO 2009/092841

(56) References cited:
- GB-A- 1 484 463
- JP-A- H10 204 615
- US-A- 4 915 057
- US-A1- 2002 093 080
- US-A1- 2003 108 805
- US-A1- 2004 020 435
- US-B1- 6 265 324

## Description

### SECTOR OF THE ART

The state of the art whereto the registered invention belongs is that of electronics and more specifically in the technology of manufacturing metal contacts and/or depositing thin insulating sheets.

### STATE OF THE ART

The new invention relates to a metal mask suitable for depositing thin films to establish tracks, contacts and insulating areas in devices and also on plates or electronic substrates. There currently exist numerous techniques for producing films (normally thin) of metals and insulators which then permit the definition of tracks of pre-set shapes and sizes. For example, in microelectronic manufacturing technology, the deposition of metal films (via evaporation or cathode-sputtering, also known as *sputtering*) and its subsequent engraving following a photolithographic process can be cited. Said process is initiated with the deposition of a photoresin on the metal. Then, the exposition thereof continues through a mask, the development of the resin, a selective engraving of the metal through the open apertures in the resin, and finally, the descaling thereof. In the development of printed circuit plates, a very similar photolithographic process can be mentioned wherein the metal film to be engraved is joined to a substrate (of fibreglass, for example) through lamination. Another commonly used method for producing metal tracks and contacts is the *lift-off* technique. In this case, a photoresin is initially deposited on the substrate to be metalized. This is insulated through a mask. The resin is subsequently developed to leave the areas of the substrate to be metalized exposed. Following this, the metal film is deposited and finally the resin is descaled. In this final step, the resin takes the metal film on top of it along with it, except for in the areas where the metal makes direct contact with the substrate. Another highly used technology for defining tracks on plates (for example in the development of hybrid circuits on ceramic substrates) is the deposition of thick films of conductive ink through templates or stencils (normally metal) which contain suitable apertures to let the ink pass through where one desires and define the patterns. In short, this is a screen printing process which is also used to selectively deposit dielectric materials.

As can be observed, in the first two selective metallization processes, the substrate is submitted to a photolithographic process. This means, on the one hand, aligning the masks which contain the patterns that one wants to transfer with the substrate. Furthermore, this is exposed to contact with various substances: photoresins, developers, metallic engraving products, etc. Screen printing and the deposition of conductive inks is generally incompatible with the metallization of semi-conductor devices or substrates, particularly due to a poor contact resistance with the pads, a low spatial resolution and the limitation of said inks regarding maximum current.

An alternative process to all of those previously mentioned is that of shadow masking. Basically, this is depositing a film of a material (for example by evaporation of sputtering) through a screen or perforated mask, which is placed between the substrate and the source of material to be deposited. Therefore, the areas which are not to be deposited can be masked without requiring the use of photoresins. This technique has been used in some fields of microelectronics, such as, for example, in the development of integrated circuits on organic substrates, as disclosed in Joo-Won Lee, Byeong-Kwon Ju, Jin Jang, Young-Soo Yoon, Jai-Kyeong Kim. "High mobility organic transistor patterned by the shadow-mask with all structure on a plastic substrate". Journal of Material Science, (2007) 42:1026-1030, or else in the development of microsystems, as disclosed in Yong-Soo Choa, Sung-Wook Janga, Young-Soo Sohnb, Sie-Young Choi. "Design and fabrication of a vibration sensor using a conductive ball". Microelectronics Journal 38 (2007) 416-421. In the former case, the substrate itself limits the use of the solvents involved in the photolithographic stages, while in the latter case, the intent is to define metal patterns on substrates which are not completely flat (they feature cavities) and which therefore do not permit a uniform deposition of photoresins. In any case, the masks or stencils used for shadow masking in the microelectronic field are delicate elements, often manufactured by using microelectronic processes which are relatively complex and expensive, as disclosed in R. M. Tiggelaar, J. W. Berenschot, M. C. Elwenspoek, J. G. E. Gardeniers, R. Dorsman and C. R. Kleijn. "Spreading of thin-film metal patterns deposited on nonplanar surfaces using a shadow mask micromachined in Si 110". Journal of Vacuum Science and Technology B, Vol. 25, No. 4, Jul/Aug 2007. pp. 1207-1215.

When the selective metallization of a specific substrate does not permit the use of standard photolithographic processes and very high precision is not required, the alternative to shadow masking based on microelectronic processes can be completely unsuitable (excessive cost of the masks, incompatibility of the substrates with the cleanliness conditions of the white rooms, etc.). The proposed invention has been developed precisely for these types of applications. Amongst these applications, we can mention the re-metallization of the upper aluminium contacts in high-powered devices to permit their subsequent welding, as disclosed in A. Petitbon, N. Martin, X. Jordà, P. Godignon, D. Flores. "Procédé de fabrication d'un composant électronique de puissance, et composant électronique de puissance ainsi obtenu". Joint European Patent ALSTOM - CNM, nº 01401764.4 - 2203. Grant date: 02-07-2001., the establishment of contacts in substrates with nanotube films, according to R. J. Chen, S. Bangsaruntip, K. A. Drouvalakis, N. W. Shi Kam, M. Shim, Y. Li, W. Kim, P. J. Utz, H. Dai. "Noncovalent functionalization of carbon nanotubes for highly specific electronic biosensors". PNAS, Vol. 100, N0. 9, April 29, 2003. pp. 4984-4989, or the direct definition of tracks on ceramic substrates. The proposed method permits the selective metallization of substrates (ceramics, laminates, metals, etc.) or of discrete semi-conductor devices (cut from their original wafer) without having to turn to photolithographic processes. The abovementioned substrates and chips do not make contact with any chemical product (photoresin, developer, etc.) and the proposed method permits the automatic alignment thereof with the mask or metallization template without requiring complex optical systems (such as those disclosed in Joo-Won Lee, Byeong-Kwon Ju, Jin Jang, Young-Soo Yoon, Jai-Kyeong Kim. "High mobility organic transistor patterned by the shadow-mask with all structure on a plastic substrate". Journal of Material Science, (2007) 42:1026-1030). This fact permits a rapid preparation of the samples to be processed and therefore, a decrease of the end costs of metallization. Other self-aligned metal mask assemblies are described in the documents GB 1 484 463 A and JP H10 204615 A.

Finally, it must be mentioned that in the state of the art in this description, we have focused on the deposition of metals, but the selective deposition technique can also be applied to other materials which can be evaporated, such as ceramics or organic compounds.

### BRIEF DESCRIPTION OF THE INVENTION

The present invention is defined by the appended claims. The field of application of the present invention is that of the selective deposition of thin films, for example metals for establishing tracks or contacts in electronic devices and substrates through evaporation, sputtering, atomization, and other systems. When the selective deposition of a specific substrate does not permit the use of standard photolithographic processes and very high precision is not required, the alternative to shadow masking based on microelectronic processes can be completely unsuitable (excessive cost of the masks, incompatibility of the substrates with the cleanliness conditions of the white rooms, etc.). The proposed invention has been developed precisely for these types of applications (for example, re-metallization of contacts for high-powered devices, contact of substrates with nanotubes, definition of tracks on ceramic substrates, etc.).

The desired film is deposited on the substrate through a mask or template with orifices which define the patterns or metal tracks (shadow masking). The alignment of the substrate with the mask is achieved by means of a second mask which features an aperture wherein the substrate fits perfectly. Both masks line up thanks to auxiliary holes made in each one of them and wherethrough guide rods are inserted. These rods are located in a metallic base which includes the auxiliary pieces which permit the assembly to be tightened. This solution for the automatic centring of the masks with the substrate avoids expensive optical systems. Furthermore, the thickness of the lower mask permits the separation between the substrates and the upper mask to be controlled. As the masks can be manufactured with the same technique used in the production of screen-printing stencils (by laser or chemical cutting), the costs are greatly reduced, maintaining a good precision (spatial resolutions of 0.1 mm are easily reached). The technique has been developed for depositing metals, but it can be used for depositing any type of material compatible with the evaporation, sputter, atomization, and other systems.

### DETAILED DESCRIPTION OF THE INVENTION

The proposed invention permits the selective deposition of materials on substrates or individual semi-conductor devices (previously cut from their corresponding wafer) by means of equipment such as evaporators or sputters, without having to turn to photolithographic processes. The broadest application of these types of processes would correspond to selective metallization. The method is based on the shadow masking technique, wherein the substrate is metalized by inserting a mask or stencil between this and the metal source. This mask features apertures wherethrough the metal can reach the substrate, the rest of the surface being screened off. The proposed method resolves the problem of the alignment of the substrate with the mask, avoiding complex optical systems and being compatible with the high vacuum conditions of the evaporation and sputtering systems. The invention is formed by four basic parts:
1- An upper metal mask (3), for example of stainless steel, with the orifices which define the patterns to be metalized (3a), plus other auxiliary centring orifices (3b). The material wherewith the mask is manufactured is not vital (in principle it can be of any other metal). Nevertheless, the stainless steel is very suitable as it is stable, strong and cheap. Additionally, the masks and stencils of this metal used in screen printing can be used in the framework of the proposed invention. This fact permits the use of masks with high resolution levels (up to 5 microns if the masks are cut by lasers) at a very attainable cost.
2- A lower mask, also metal (4), with orifices of the same size and shape as the substrates or devices to be metalized (4a), plus the corresponding auxiliary centring holes (4b). The thickness of this lower mask permits the distance of separation between the surface of the substrate and the upper mask to be controlled. This point is important as it permits the mask to remain separate from the substrate by a certain pre-established distance (for example, in case there is some type of material sensitive to the pressure which may be applied on the surface of the substrate). On the other hand, if one wants to eliminate any type of side-scatter of the deposited material, the thickness of the mask can be chosen so that it makes contact with the upper surface of the substrate. The previous comments on materials and manufacture of the upper mask are fully applicable to the lower mask. Again, it is interesting to take advantage of the well-established technology of stencil manufacturing for screen printing, as it makes a wide variety of different thicknesses available for being able to adjust the thickness of the substrate or device to be deposited or metalized.
3- A piece (5) which permits the centring of the upper and lower masks thanks to rods (5b) corresponding to the auxiliary holes of the masks (3b and 3c). The placement of the rods on the piece (5) must be done with the greatest precision possible, as this placement partly determines the precision with which the masks can be lined up with each other and with the substrate. Positioning the rods with a precision lower than 50 microns is not at all problematic with the current numeric control tools. The material wherefrom this piece is manufactured is not vital and can be of aluminium.
4- A piece or frame (2) which permits the adjustment and securing of the entire system thanks to the different tightening screws (10), and to the through and screw holes (7 and 8, respectively) made in the different pieces. The material wherefrom this piece is manufactured is not vital and can be of aluminium.

The substrates and chips to be metalized (9) do not come into contact with any chemical product (photoresins, developers, etc.) and the proposed method permits the automatic alignment thereof with the mask or metallization stencil. An important aspect is that the masks can be manufactured with the currently available technology for making screen printing templates or stencils. Said templates are cut and perforated by laser or by chemical engraving, producing high precision in both the centring and the definition of the patterns. Furthermore, the fact of using a very broad technology for the production of printed circuit plates (the stencils for screen printing), permits a reduction in the costs of the masks and a conservation of the high precision.

The procedure or method of use of the invention presented herein is the following. In the deposition process, the operator first secures the mask 4 on the base 5 with the suitable screws. Subsequently, the substrates to be metalized 9 are placed inside the open apertures on the lower mask 4. Then the upper mask 3 is placed on the assembly, the metallization patterns 3a being automatically aligned with the substrates 9 thanks to the centring holes 4b made in the two masks and to the rods 5e of the base 5. Finally, the frame 2 is screwed on to secure the masks to the base, and the assembly can in turn be secured on a plate of the deposition equipment (evaporator, etc.) together with other similar mask assemblies, which permits the deposition of material on a larger number of substrates in each process.

### DETAILED DESCRIPTION OF THE DRAWINGS

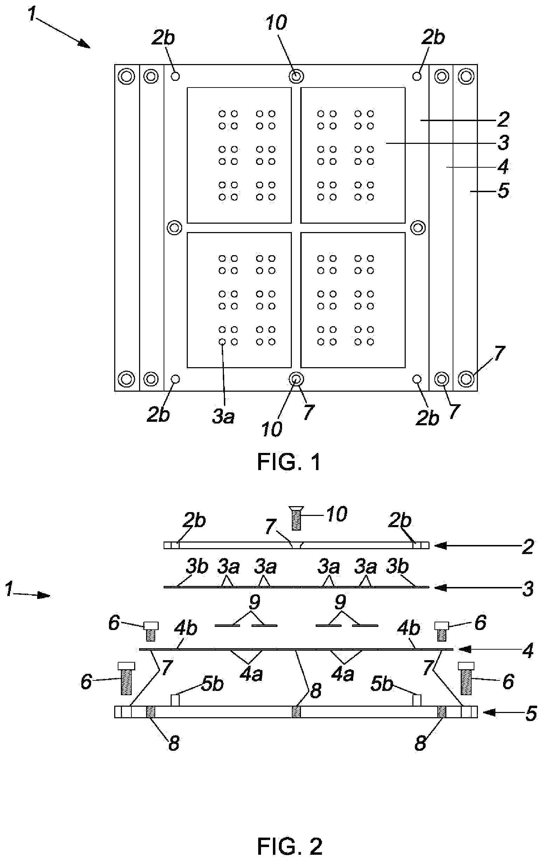

**Figures 1 and 2** show a schematic of a plan view and an exploded side view of the entire assembly of pieces used for the selective deposition.
   2: Piece or frame which permits the tightening and securing of the entire system.
   3: Upper metal mask.
   4: Lower metal mask.
   5: Base or piece which permits the centring of the upper and lower masks.
   5b: Centring rods.
   3b: Auxiliary centring holes.
   9: Substrates and devices to be metalized or deposited.
   3a: Orifices which define the patterns to be metalized.
   6: Tightening screws.
   7: Through holes.
   8: Screw holes.
**Figure 3** shows an example of embodiment. It represents a perspective view of the upper frame which permits the tightening and securing of the entire system, made of aluminium.
**Figure 4** shows an example of embodiment. It represents a perspective view of the upper mask made of stainless steel. It features the necessary orifices for metalizing the upper pads of 112 IGBT power transistors.
**Figure 5** shows an example of embodiment. It represents a perspective view of the lower stainless steel mask where 112 IGBT transistors are housed.
**Figure 6** shows an example of embodiment. It represents a perspective view of the base piece which permits the centring of the upper and lower masks, made of aluminium and with 4 steel centring rods.
**Figure 7** shows an example of embodiment. It represents one of the IGBT transistors metalized with the proposed method. One span indicates the three metalized zones (two upper side zones and one lower central zone).

### EXAMPLE OF EMBODIMENT

The example of embodiment presented herein consists of the practical implementation of the system shown in Figures 1 and 2 for metalizing the upper pads of high-power devices, specifically IGBT transistors. The lateral dimensions of the devices used are 6.5 mm x 4.87 mm with a thickness of 140 microns. The objective is to be able to deposit a triple layer of titanium, nickel or gold (Ti/Ni/Au) on the upper aluminium pads of the device, in order to permit their subsequent welding by means of tin / lead / silver or similar alloys.

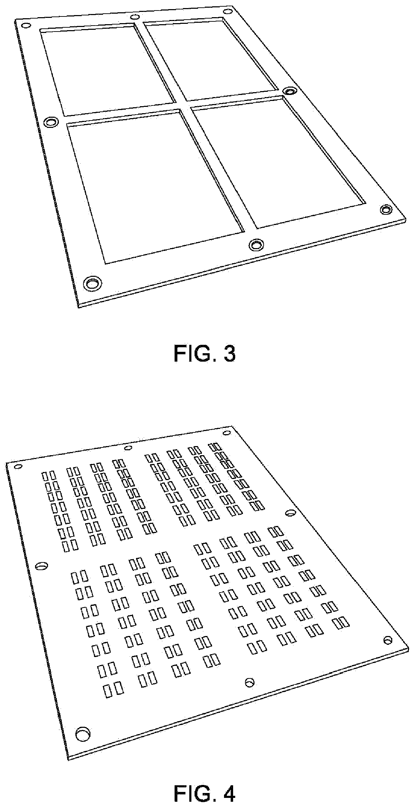

Figure 3 shows the upper frame (A) mechanized in aluminium. Its external dimensions are 140 mm x 110 mm x 3 mm and the 4 internal windows are 58 mm x 43 mm. In Figure 3 one can also observe the 4 centring holes (4b) in the corners of the frame and another 4 through holes for the fastening screws of the frame 2. This is situated on the upper mask (3), shown in Figure 4, of the same lateral dimensions as the frame 2 and with a thickness of 200 microns. This mask has been made of stainless steel cut by laser, using the technology normally used for making screen printing templates or stencils. This fact allows for the production of high resolutions (more / less 5 microns in the current case) at a low price. The upper mask of Figure 4 permits 112 chips to be metalized. In the location of each one of the chips the mask features 2 rectangular holes with the holes rounded to metalize the large emitter pads, as well as a small rectangular hole situated between the 2 previous ones to metalize the gate pad of the IGBT, with the corners also rounded. The dimensions of the rectangular holes of the emitter are 3.1mm x 1.5mm and those of the central hole of the gate are 0.85mm x 0.85mm. The proposed system implemented as described herein permits a minimum centred resolution estimated at 0.1 mm. Also observable in Figure 4 are the 4 centring holes in the corners (4b) and another 4 through holes for the fastening screws of the frame 2.

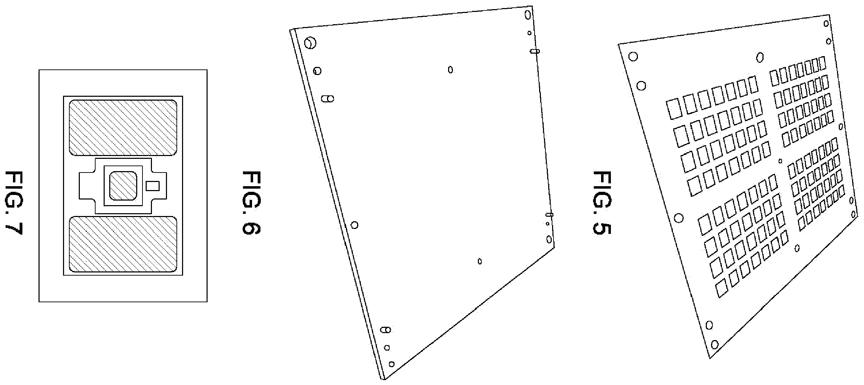

Figure 5 shows the lower mask, also of stainless steel and manufactured by the same means as the previous one. This mask features the 112 6.5mm x 4.87mm apertures which will house another 112 IGBT devices of these dimensions (9). In reality, and in order to ensure that the devices perfectly fit the dimensions of the apertures, they have been made 10 microns larger. This permits an easy placement of the chips, but an excessive margin can compromise the precision of the alignment. The thickness of the lower mask is chosen to be equal to or as close to possible of that of the device to be metalized. For the production of screen printing stencils there are a large number of thicknesses available, having chosen a mask of 150 microns for the current case (the nominal thickness of the device is 140 microns). The lateral dimensions of the lower mask are 150mm x 110mm and it is secured to the lower base thanks to 4 screws (6). Also observable in Figure 5 are the 4 through holes in the corner for said screws, with the centring holes (2b) next to them and another 4 through holes for the fastening screws of the frame 2.

The base or piece which permits the centring of the upper and lower masks with the device to be metalized can be observed in Figure 6. This piece has been made of aluminium and its dimensions are 160mm x 110mm x 5mm. It features 4 through holes (7) in the 4 corners to permit its fastening on the plate or sample-holder of the metallization equipment (evaporator or sputter). The 4 screw holes (8) which permit the lower mask 4 to be screwed to the base 5, as well as another 4 screw holes which permit the securing frame 2 to be screwed to the same base 5 can be observed together with these through holes. Also visible in Figure 6 are the 4 steel rods (5b) which correspond to the centring holes (2b) of the two masks (3 and 4) and which permit the centring thereof.

Finally, Figure 7 shows the upper face of an IGBT device after the selective metallization process with Ti/Ni/Au, using the proposed method and the system. The two large, lined rectangles can be observed on both sides of the chip, on the upper pad of the aluminium emitter. Between both of these, the central metallization framed within the gate pad of the device is observed.

## Claims

1. Self-aligned metal mask assembly (1) for selectively depositing thin films of material on microelectronic substrates and devices (9), **characterised in that** it consists of:
a) an upper metal mask (3), which comprises orifices (3a) which define patterns to be deposited on the device or substrate (9) and centring holes (3b);
b) a lower metal mask (4), which comprises orifices (4a) of the same size and shape as the devices or substrates (9) whereon one wishes to deposit the material and centring holes (4b) and screw holes (7);
c) b1) substrate (9) placed inside orifice (4a);
d) a base piece (5) which comprises rods (5b) which correspond to the centring holes (3b, 4b) which centre the upper metal mask (3) with the lower metal mask (4); and
e) an upper frame (2), which comprises centring holes (2b) and holes (7) which secure and maintain the assembly (1), aligned by means of screws (10);
wherein the lower metal mask (4) has a thickness equal to or thicker than the thickness of the substrate (9) in such a way that said thickness of the lower mask (4) defines a separation distance between the substrate (9) and the upper metal mask (3).

2. Method of assembling the assembly (1) of self-aligned metal masks for selectively depositing thin films of material on microelectronic substrates and devices (9) of claim 1, **characterised in that** it comprises the following steps:
- securing the lower metal mask (4) on the base piece (5);
- placing substrates (9) whereon the material is to be deposited inside the orifices (4a) of said lower metal mask (4);
- securing the upper metal mask (3) on the lower metal mask (4), the patterns to be placed with the substrate by means of the centring holes (3b, 4b) and the rods (5b) of the base piece (5) being automatically aligned; and
screwing the upper frame (2) to the base piece (5), the two metal masks (3, 4) and the substrate (9) being aligned therebetween.

## Patentansprüche

1. Selbstausgerichtete Metallmaskenanordnung (1) zum selektiven Abscheiden dünner Materialfilme auf mikroelektronische Substrate und Vorrichtungen (9), **dadurch gekennzeichnet, dass** sie besteht aus:
a) einer oberen Metallmaske (3), die Öffnungen (3a) umfasst, die auf der Vorrichtung oder dem Substrat (9) abzuscheidende Muster und Zentrierlöcher (3b) definieren;
b) einer unteren Metallmaske (4), die Öffnungen (4a) von gleicher Größe und Form wie die Vorrichtungen oder Substrate (9) umfasst, auf denen das Material und die Zentrierlöcher (4b) und Schraubenlöcher (7) abgeschieden werden sollen;
c) b1) Substrat (9), das innerhalb der Öffnung (4a) angeordnet ist;
d) einem Basisstück (5), das Stäbe (5b) umfasst, die den Zentrierlöchern (3b, 4b) entsprechen, die die obere Metallmaske (3) mit der unteren Metallmaske (4) zentrieren; und
e) einem oberen Rahmen (2), der Zentrierlöcher (2b) und Löcher (7) aufweist, die die Anordnung (1) sichern und halten und mittels Schrauben (10) ausgerichtet sind;
wobei die untere Metallmaske (4) eine Dicke aufweist, die gleich oder dicker als die Dicke des Substrats (9) ist, so dass die Dicke der unteren Maske (4) einen Trennungsabstand zwischen dem Substrat (9) und der oberen Metallmaske (3) definiert.

2. Verfahren zum Montieren der Anordnung (1) von selbstausgerichteten Metallmasken zum selektiven Abscheiden dünner Materialfilme auf mikroelektronische Substrate und Vorrichtungen (9) nach Anspruch 1, **dadurch gekennzeichnet, dass** es die folgenden Schritte umfasst:
- Befestigen der unteren Metallmaske (4) am Basisstück (5);
- Platzieren von Substraten (9), auf die das Material innerhalb der Öffnungen (4a) der unteren Metallmaske (4) abgeschieden werden soll;
- Befestigen der oberen Metallmaske (3) an der unteren Metallmaske (4), wobei die mit dem Substrat zu platzierenden Muster mittels der Zentrierlöcher (3b, 4b) platziert werden und die Stäbe (5b) des Basisstücks (5) automatisch ausgerichtet werden; und
Verschrauben des oberen Rahmens (2) mit dem Basisstück (5), wobei die beiden Metallmasken (3, 4) und das Substrat (9) dazwischen ausgerichtet sind.

## Revendications

1. Ensemble de masques métalliques auto-alignés (1) pour le dépôt sélectif de films minces de matériau sur des substrats et des dispositifs microélectroniques (9), **caractérisé en ce qu'**il consiste en :
a) un masque métallique supérieur (3), qui comprend des orifices (3a) qui définissent des motifs à déposer sur le dispositif ou substrat (9) et des trous de centrage (3b) ;
b) un masque métallique inférieur (4), qui comprend des orifices (4a) de même taille et forme que les dispositifs ou substrats (9) sur lesquels on souhaite déposer le matériau et des trous de centrage (4b) et des trous de vis (7) ;
c) b1) substrat (9) placé à l'intérieur de l'orifice (4a) ;
d) une pièce de base (5) qui comprend des tiges (5b) qui correspondent aux trous de centrage (3b, 4b) qui centrent le masque métallique supérieur (3) avec le masque métallique inférieur (4) ; et
e) un cadre supérieur (2), qui comprend des trous de centrage (2b) et des trous (7) qui fixent et maintiennent l'ensemble (1), alignés au moyen de vis (10) ;
dans lequel le masque métallique inférieur (4) a une épaisseur égale ou supérieure à l'épaisseur du substrat (9) de telle sorte que ladite épaisseur du masque inférieur (4) définit une distance de séparation entre le substrat (9) et le masque métallique supérieur (3).

2. Procédé d'assemblage de l'ensemble (1) de masques métalliques auto-alignés pour le dépôt sélectif de films minces de matériau sur des substrats et des dispositifs microélectroniques (9) de la revendication 1, **caractérisé en ce qu'**il comprend les étapes suivantes :
- fixer le masque métallique inférieur (4) sur la pièce de base (5) ;
- placer des substrats (9) sur lesquels le matériau doit être déposé à l'intérieur des orifices (4a) dudit masque métallique inférieur (4) ;
- fixer le masque métallique supérieur (3) sur le masque métallique inférieur (4), les motifs à placer avec le substrat au moyen des trous de centrage (3b, 4b) et les tiges (5b) de la pièce de base (5) étant automatiquement alignés ; et
visser le cadre supérieur (2) sur la pièce de base (5), les deux masques métalliques (3, 4) et le substrat (9) étant alignés entre eux.
